# EUROPEAN PATENT SPECIFICATION

(11) **EP 0 670 668 B1**
(45) Date of publication and mention of the grant of the patent: **28.01.1998**
(21) Application number: 94117039.1
(22) Date of filing: 27.10.1994
(51) Int. Cl.: H05K 3/42, H01L 21/70

(54) **Process for the provision of metallized holes in dielectric substrates comprising interconnected thin film conductive and/or resistive paths**
Verfahren zur Herstellung von metallisierten Löchern in dielektrischen Substraten mit untereinander verbundenen Dünnschichtleiter- und/oder Widerstandsbahnen
Procédé pour la production de trous métallisés dans des substrats diélectriques comportant des voies conductrices et/ou résistives interconnectées à film mince

(30) Priority: 22.12.1993 IT MI932697; 22.12.1993 IT MI932698
(43) Date of publication of application: 06.09.1995
(73) Proprietor: Italtel s.p.a., 20149 Milano (IT)
(72) Inventor: Bertolotti, Massimo, I-20060 Gorgonzola (Milano) (IT); Carcano, Giorgio, I-20043 Arcore (Milano) (IT); Carminati, Anna, I-24042 Capriate S. Gervasio (Bergamo) (IT); Ceriani, Maurizio, I-20157 Milano (IT)

(56) References cited:
- EP-A- 0 238 118
- EP-A- 0 333 252
- DE-A- 3 524 832
- US-A- 4 226 932
- US-A- 4 402 998

## Description

The present invention relates to the field of industrial processes for achievement of hybrid thin film circuits for microwave applications and specifically to a process for the provision of metallized holes in dielectric substrates comprising conductive and/or resistive paths.

As known, thin film circuits are provided predominantly on a single face of a dielectric substrate in the form of an alumina plate whose other face comprises an extended metallization which acts as a ground plane. It is a common circuitry requirement to have one or more points connected to ground which, in thin film technology, takes place generally through metallized holes. The latter are holes having metallization adhering to the walls delimiting them in the body of the substrate, i.e. metallization which extends beyond the edges of the hole to cover partially the conductive paths on the front side and providing electrical continuity between the conducting paths on one side and the ground plan on the other.

The technology for providing metallized holes in dielectric substrates is a recent technology and hence capable of further improvements as shown in fact by the shortcomings present in all the industrial processes known to date and which are shown by describing below two of the more significant of said processes.

A process for providing metallized holes in a dielectric substrate in e.g. known from DE-A-3 524 832.

A first process is, for example, described in the article by R.J. Thompson and B.W. Whitaker entitled "CONDUCTIVE VIA PROCESSING UTILIZING RF SPUTTERING AND SELECTIVE ELECTRODEPOSITION FOR HYBRID THIN FILM CIRCUITS" published in the Proceedings of the 32nd Electronic Components Conference, San Diego, California, 1982. The article analyses first some of the principal pr-existing methods for the provision of metallized holes on dielectric supports for the purpose of framing them in a single conceptual scheme comprising three steps. In the first of said steps is provided on the front side of the dielectric support the creation of a circuit comprising resistors and conductors achieved by known thin film techniques. The second step provides drilling of the substrate thus achieved. The third step provides creation of the conductive connection through the holes by vacuum cathode sputtering of metal performed on the back side of the substrate. The third step is further investigated taking into consideration different manufacturing approaches which are subsequently compared for choice of the best suited one. The comparison consists of appraising the percentage of processing rejects caused by lack of electric continuity through the holes depending on the diameter thereof. The approach which proved to be best suited, and hence proposed industrially, is the one which provides thorough cleaning of the holes before sputtering the back with titanium and platinum (or palladium) in thickness four times greater than standard and gold in thickness less than standard. After the sputtering step follows a galvanic deposition of gold in the same thickness, or greater, than standard. The total thickness of gold is at the end approximately double standard. The majority of metallic thicknesses, together with the perfect verticality of the hole walls, are indispensable requisites to allow the rear deposited metals to reach the front side of the substrate through the holes in sufficient quantities to ensure good electrical continuity.

The above remarks show clearly the shortcomings of the described process due mainly to the excessive thicknesses required for the metallization deposited from the back and by the fact that a perfect verticality of the hole walls is in practice difficult to achieve.

To correct the shortcomings set forth above there has been developed in the name of this applicant a second process for provision of metallized holes as set forth in Italian patent no. 1216135 having Italian priority 18/3/1988 to which also corresponds a European patent no. 0333252 granted 23/6/1993. Specifically said second process concerns the provision of metallized holes in a dielectric substrate having conductive and/or resistive paths on one side, called hereinafter front side, the other side being called hereinafter back side, which comprises essentially the following steps in succession: a) galvanic growth of conductive paths delimited by a first photosensitive lacquer (photoresist) on said front side, b) drilling of the substrate, c) covering of the front side with a layer of a second negative photosensitive lacquer, exposure with mask and development to form bare circular coronas around said conductive paths in correspondence of the holes, d) galvanic growth of metal on the front side and achievement of metallic rivets projecting inside the holes as extensions of said conductive paths, e) removal of said second photosensitive lacquer and completion of the conductive paths and/or resistive paths, f) vacuum deposition on the back side of metals which diffuse also on side walls of said holes until they join electrically with the projections of said metallic rivets, g) covering of the front side with another layer of said second photosensitive lacquer and development with said mask, h) galvanic growth of gold on the back side, side walls of the holes and front side in the areas not covered by said second lacquer.

The innovation basically introduced in this second process was that of having fabricated rivets projecting in the holes whose presence, prescinding from the observations made below, should allow achievement of the continuity of the front/rear contact without the use of high thicknesses of metal even in the presence of not perfectly vertical holes.

However even this second process is not without shortcomings. A first shortcoming is caused by the unavoidable chipping which occurs on the edges of the holes during drilling of the substrate and generally performed with an ultrasonic or laser drill. To better understand the reasons for which the chips can cause shortcomings it is necessary to review critically the first two steps of the second known process concerning the galvanic growth of front side conductive paths and the drilling of the substrate. As shown clearly in the example and the annexed figures, the steps of the process relate to semi-finished products consisting of dielectric substrates which exhibit all over the front side surface a uniform metallization comprising three overlying layers of tantalum nitride, titanium and palladium. The drilling of the substrate is in reality a drilling of the substrate and of the overlying metallic layers, there not being provided, for reasons clarified below, a step of removal of said metals from the areas adjacent to that of drilling. In view of this and because of unavoidable chipping of the edge of the substrate during drilling, the metallic layers present in the chipped areas undergo partial detachment which prevents the metal of the rivets from covering galvanically the chipped areas without metallization. Nor are these chipped areas covered at the end of the subsequent step of vacuum cathode deposition of metals performed from the rear because of the difficulties encountered by the metal in reaching the chipped areas penetrating into the holes from one side only, especially in the presence of unavoidable irregularities in the walls thereof. The lack of metallization obstructs consequently also the galvanic growth of gold in said chipped areas during the final step of the process with a resulting loss of front/rear continuity there.

The same type of shortcoming can appear even by another way, i.e. it can be caused by the fact that the step of obtaining the resistive elements is subsequent to that of achieving the rivets. As known, achieving resistors from multilayer paths requires a selective chemical etching of the metallic layers overlying the resistive layer adhering to the substrate. During etching, the rivets are protected by the same photoresist used for delimiting the resistive paths but the protection is in general not ensured on the corner of the holes because of the difficulty of covering them by the photoresist. The chemical etching consequently produces a partial engraving of the metal of the rivets and consequently the circular edges of the rivets along the corners of the holes do not have in reality the regularity shown in the figures. In particular, there can occur a loss of continuity with the metallic material of the substrate. There is thus produced by another way a situation analogous to that already seen considering the chips on the substrate caused by the drilling, but this time the damage is more extensive.

From the above remarks it can bee seen that the presence of the rivets, although correcting the main shortcomings of the first known process, is not capable of ensuring good electrical contact along the corners of the holes, mainly due to lack of continuity with the conductive material of the substrate at the edges thereof. Therefore the existence of said conductive material is basic for the above process and the above remarks concerning the fact that the process did not call for a removal step prior to the galvanic growth of the rivets and photoengraving of the resistors consequently appears justified. Even if this step were called for, the rivets could not grow galvanically in contact with the substrate and welding therewith. Indeed there would be an area without metallization between the substrate and the rivets which the vacuum cathode deposition of metals performed only from behind would not be capable of filling, thereby causing discontinuity even in the subsequent step of galvanic gold deposition.

Considering a generic hole, the overall loss of front/back continuity due to all the causes mentioned would bring about an increase of the contact resistance of the hole, which can reach intolerable values and make rejection of the part unavoidable. There is thus shown the nature of the main shortcomings of the second known process which, despite the complications of fabrication of the rivets, does not ensure a high productive output.

Accordingly the purpose of the present invention is that of overcoming the above shortcomings and indicating a process for the provision of metallized holes in dielectric substrates comprising thin film conductive and/or resistive paths and having high production output.

To achieve said purposes, the object of the present invention is a process for the provision of metallized through holes in a dielectric substrate having front and back sides and conductive and/or resistive paths covered with metallic layers on the front side of the substrate, characterised in that it comprises in succession the following steps:
a) drilling of said substrate in areas free of metallization of said conductive and/or resistive paths,
b) thorough cleaning of said front and back side of the dielectric substrate and of the walls delimiting the holes in the body of the substrate,
c) vacuum cathode sputtering of metals on said front and back sides and on the walls of the holes, achieving electrical continuity between the front and back side of the dielectric substrate through the holes,
d) covering of the front side with a layer of a negative photosensitive emulsion termed hereinafter photoresist, and masking of areas entirely overlying the holes and partially overlying said conductive and/or resistive paths, exposure and development of the masked photoresist, achieving uncovered circular areas around the front side edges of the holes
e) galvanic growth of metal over said front side uncovered circular areas around the edges of holes, on said walls delimiting the holes in the body of the substrate, and on the all back side surface, forming a ground plane,
f) removal of the residual photoresist from the front side, and
g) removal of said sputtered metals which are uncovered from said galvanically grown metal from the front side , as described in claim 1.

The process which is the object of the present invention corrects the shortcomings of the first known process since the vacuum cathode deposition of metals performed both on the front side and the rear side allows the metals deposited on both sides of the substrate to more easily come in contact through the holes. Therefore it is no longer necessary to increase the thicknesses of the metallic layers, and perfect verticality and regularity of the hole walls is no longer necessary. Furthermore, thanks to the uniformity of the metallic covering achieved, the layer of gold galvanically grown appears uniform and without breaks through the hole, and a standard thickness is hence sufficient to establish good electrical contact between front and rear. The uselessness of the rivets, which are not provided in the process which is the object of the present invention, appears evident, thus eliminating all the shortcomings of the second known process attributable thereto. As concerns the chips on the edges of the substrate caused by drilling, they are no longer a cause of damage since, like the annular areas of bare substrate at the edges of the holes, they are easily covered by metals deposited front & back.

The process for achievement of metallized holes which is the object of the present invention exhibits, in comparison with the second known process, various advantages of which a first is certainly that of increasing production output considerably. A second advantage is due to the fact of providing completion of the resistors before drilling of the substrate. The necessity of protecting the edge of the holes during selective chemical etching for achieving resistors is thus avoided. It should be noted that the selective chemical etching of the metals on the front side, performed in the final step of the process, has no negative consequences as concerns the metallic and electric continuity through the holes just because said etching is not addressed to the outer layer of the metallization which covers the hole walls. A third advantage is the fact that the vacuum cathode deposition of metals performed both front and read ensures excellent repeatability and continuity of the metallization achieved in this manner. In particular, it is not influenced by the morphological appearance of the holes nor their imperfect verticality. A fourth and last advantage consists of the saving of the gold of the rivets.

All the advantages mentioned above are certainly found as long as the width of the conductive paths does not fall below 50 µm approximately, after which any chemical etching performed on the front side on areas not protected by photoresist, and in particular that of the final step g) which removes the metals deposited cathodically in step c) being outside the metal deposited galvanically in step e), can cause underetching in correspondence of the conductive paths, of an extent such as to threaten the adherence of the metallic lines to the substrate.

This new shortcoming is corrected by a variant of the process which is the object of the present invention, which allows achievement of metallized holes even in substrates having conductive paths of width less than approximately 50 µm while preserving all the above mentioned advantages of the main process. Said variant allows avoiding the chemical etching performed in the above said final step g) because on the front side, as seen below, the metals deposited cathodically remain only in the area designed for galvanic metal growth, i.e. along the edges and on the walls of the holes. It must be premised that, for the variant, any front side chemical etching in areas unprotected by photoresist is avoided.

Accordingly, another object of the present invention is a variant in which the steps of the process set forth above are performed in a different order, some of them are repeated, a new step is introduced, and the final step is abolished. Specifically the process in accordance with the variant comprises in succession the following steps:
l) drilling of said substrate in areas free of the metallization of said conductive and/or resistive paths,
m) thorough cleaning of said front and back side of the dielectric substrate and of the walls delimiting the holes in the body of the substrate,
n) covering of the front side with a layer of a negative photosensitive emulsion termed hereinafter photoresist, and masking of areas entirely overlying the holes and partially overlying said conductive and/or resistive paths, exposure and development of the masked photoresist, achieving uncovered circular areas of the bare substrate at the front side edges of the holes,
o) thorough cleaning of said bare areas at the edges of the holes and inside them,
p) vacuum cathode sputtering of metals over the front side residual photoresist , on said circular areas of the bare substrate at the edges of the holes, on said walls delimiting the holes in the body of the substrate, and on the all surface of the back side, achieving electrical continuity between the front and back side of the dielectric substrate through the holes,
q) lift-off of said residual photoresist and of the metals overlying it from said front side,
r) covering of the front side with a layer of a negative photoresist and masking of areas entirely overlying the holes and partially overlying said conductive and/or resistive paths, exposure and development of the masked photoresist achieving uncovered circular areas of said sputtered metals residual after lift-off, at the front side edges of the holes,
s) galvanic growth of metal over said front side uncovered circular areas of the residual sputtered metals, on said walls delimiting the holes in the body of the substrate, and on the all back side surface, forming a ground plane, and
t) removal of said residual photoresist from the front side as set forth in claims 7.

A peculiarity of the variant which is the object of the present invention is that the conductive paths and/or resistive paths are achieved by operations which do not include front side chemical etching in areas unprotected by photoresist.

The process in accordance with the variant introduces the additional substantial advantage of aiding circuit miniaturisation. By way of example, there are indeed encountered high production outputs in the provision of metallized holes 0.5 mm in diameter at which converge metallic lines 20 µm wide, dimensions both of the hole and the lines which can be still significantly reduced.

Two further variants of the present inventions are defined in independent claims 2 and 8.

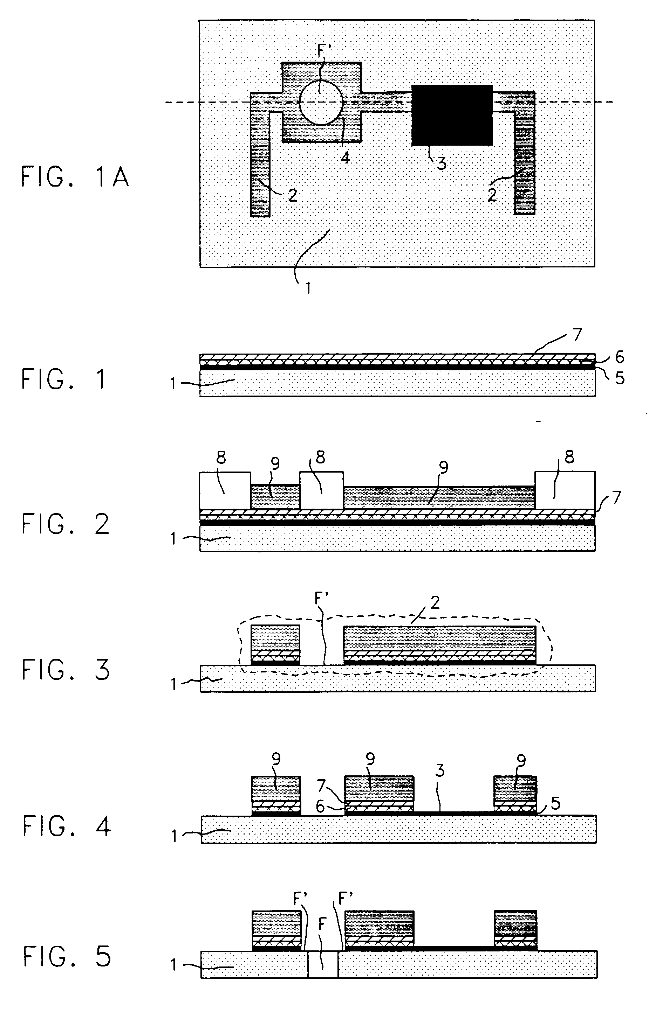

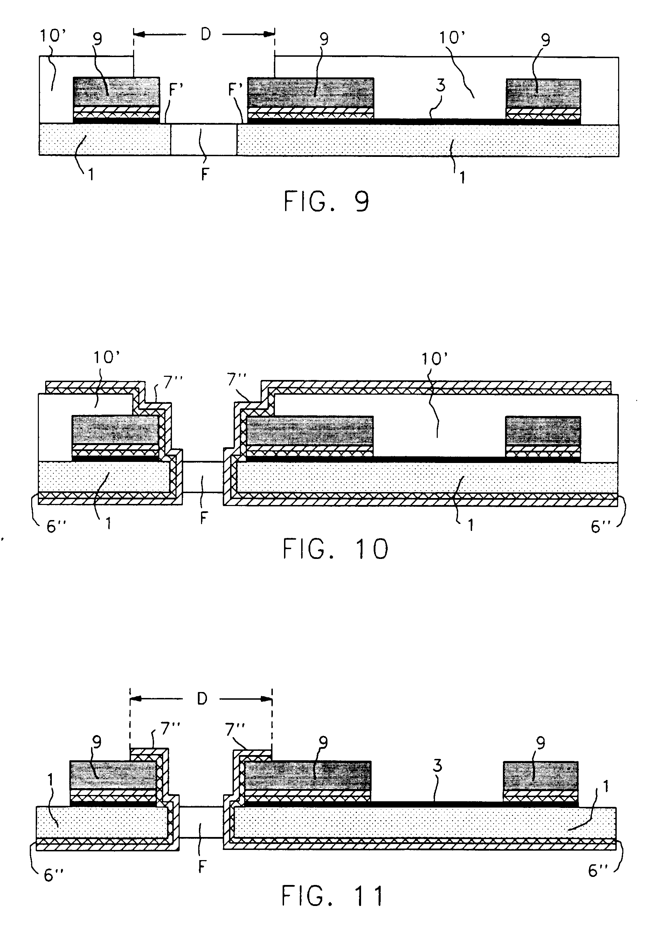

Further purposes and advantages of the present invention are clarified in the detailed description of an embodiment thereof given below by way of nonlimiting example with reference to the annexed drawings wherein the principal manufacturing steps are illustrated in FIGS. 1 to 8 of the annexed drawings and of a variant thereof whose principal manufacturing steps are illustrated in FIGS. 9 to 13 of the annexed drawings. The manufacturing steps of the present invention and of the variant are illustrated below with common reference to FIG. 1A which shows an example of a semi-finished product obtained by means of the not claimed manufacturing steps illustrated in FIGS. 1 to 4.

For drawing convenience the dimensions of the elements shown therein do not correspond to those of a real situation.

FIG. 1A shows a flat substrate, e.g. of alumina or other material used as a substrate in thin film electronic technology on one face of which, called hereinafter front side, is seen a conductive path 2 interrupted by a resistive path 3 interconnected therewith. The conductive path 2 comprises also a pad 4 at the centre of which is seen a round area F' without metallization. FIG. 1A also shows an axis representing the outline of a cross section plane cutting perpendicularly the substrate 1 along the centre line of the round area F' and along a direction of the conductive path 2 and resistive path 3. The following figures 1 to 12 are without distinction referred to cross sections of the front or rear part of the substrate 1 in relation to said cross section plane. For drawing convenience the thicknesses of the elements shown there do not correspond to those of the true case. Furthermore for the same reason opposite the round area F' there is not shown everything which would be seen beyond the cross section plane.

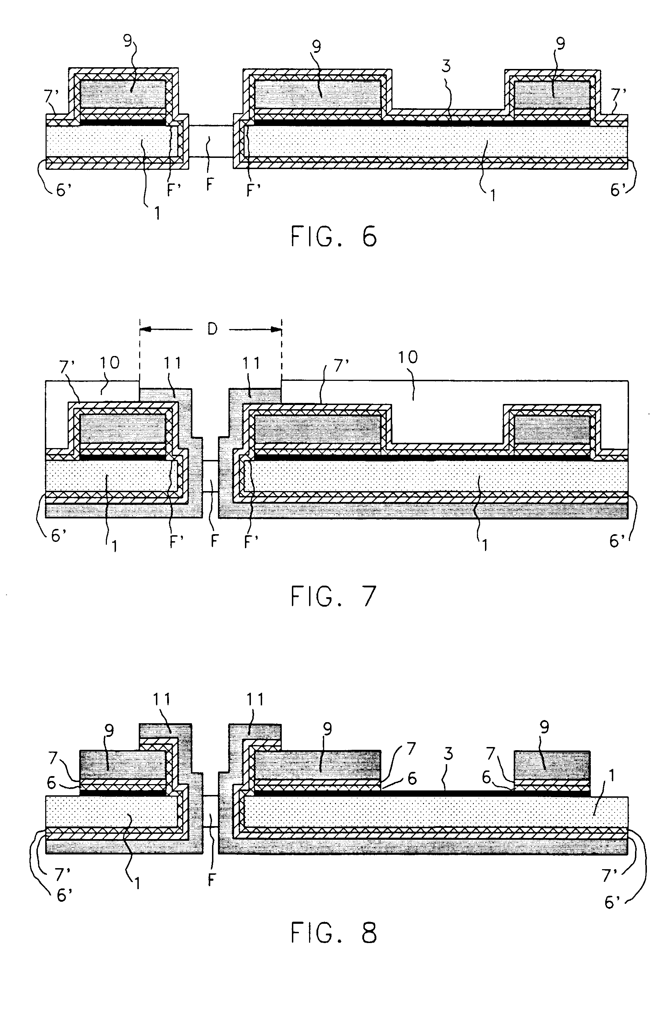

FIG. 1 refers to an initial step of the process during which on the front side of the substrate 1 are deposited three overlying metallic layers 5, 6 and 7 of standard thickness, using for the purpose one of the known methods of physical metal deposition, as for example is the deposition method for vacuum cathode sputtering of metals described in patent US-A-4226932 by means of which can be obtained the three metallic layers without interrupting the vacuum cycle. Of the three layers deposited the innermost 5 adhering to the substrate 1 consists of resistive metal, e.g. tantalum or its compounds with nitrogen and oxygen. The intermediate layer 6 consists of adhesion metal, e.g. titanium. Lastly the outer layer 7 consists of a good conducting metal having antidiffusive behaviour such as for example palladium. The layer 5 taken alone constitutes the material of the resistive path 3 of FIG. 1A while taken together with layers 6 and 7 it contributes, after superposition of another layer of gold indicated by 9 in FIG. 2, to provision of the conductive path 2. To provide layers 5, 6, 7 and 9 there can be used all those materials having analogous electrical and physical characteristics whose use is known in thin film technology.

With reference to FIG. 2 the outer layer 7 is first covered uniformly with an emulsion 8 photosensitive to ultraviolet radiation, hereinafter termed photoresist, and over which is applied a mask not shown in the figures and opaque to said radiation, in the areas of the paths 2, 3 and 4 excepting the area F'. This is true only for the use of a negative photoresist 8 while for positive photoresist the mask to use should be opaque in the area complementary to the previous one. Through the mask the photoresist 8 is exposed to ultraviolet light and then developed. In both cases the part of photoresist corresponding to said paths 2, 3 and 4, except the area F', is eliminated chemically during development. In the areas of the metallic layer 7 free of photoresist 8 is grown galvanically a layer of gold 9 to complement the conductive path 2, which in this step is not yet differentiated from the resistive path 3.

With reference to FIG. 3, after growth of the layer of gold 9 of the preceding step, the residual photoresist after developing is removed chemically; after which the layers 5, 6 and 7 are removed from all the areas not covered by the layer of gold 9. In the case of lines wider than approximately 50(m removal takes place by chemical etching but otherwise by means of dry etching in plasma which does not require under-incision of the metallic lines and related detachment. In both cases, what remains is only the conductive path 2 at the two sides of the area F' without metallization.

With reference to FIG. 4 there is thus obtained the resistive path 3 by utilising the known art, i.e. deposition of photoresist, photomasking of the resistive path 3, development and selective chemical removal of the layers of gold 9, palladium 7 and titanium 6 above the layer of tantalum nitride 5 which constitutes the resistive path 3. The methods and reagents employed in the selective chemical etching of the layers 9, 6 and 7 are known to those skilled in the art.

Then, according to the present invention, there follows a step of drilling of the substrate 1 in the centre of said area F' without metallization. FIG. 5 shows a hole F obtained by means of known drilling systems using for example ultrasonic or laser drills. The cross section of the hole F can have a form other than circular and perfect verticality of the walls of the substrate 1 are not required to delimit the hole. As may be seen the hole F does not cover the entire area F' and at the front side edge of the hole remains a circular corona of substrate 1 without metallization.

The steps thus far indicated and referring to FIGS. 1 to 5 do not exhibit limitations due to the width of the conductive path 2. The subsequent steps are discussed with reference to FIGS. 6, 7 and 8 which complete the process which is the object of the present invention and are applicable only if the width of the conductive path 2 remains greater than 50 µm approximately.

At the end of the above drilling step there is performed a rough washing of the substrate to remove the drilling residues, followed by a more accurate chemical cleaning of the substrate 1 and of the seat of the hole F.

With reference to FIG. 6, there follows a step of front & back deposition of a titanium layer 6' on which is overlain a palladium layer 7' and the thicknesses of the metallic layers 6' and 7' are standard. In this case also it is convenient to use the cathode sputtering technique in a vacuum described in patent US-A-4226932 already used for deposition of the layers 5, 6 and 7. The front & back cathodic depositions take place in two distinct vacuum cycles and this is a limit on the present technology of deposition equipment. The process which is the object of the present invention would not undergo however significant changes when in the future the limitation in this sense is made obsolete by the use of technologically more advanced equipment.

The metallization obtained at the end of the deposition step appears uniform and covers without a break the following parts: the entire surface of the back side of the substrate 1, the wall delimiting the hole F in the body of the substrate 1, the area F' of the substrate 1 at the edge of the hole F, the entire surface of the front side of the substrate 1 where it overlies the conductive path 2 and the resistive path 3. Any chipped edges of the substrate 1 at the edges of the hole F are also covered uniformly by the deposited metals.

With reference to FIG. 7 the entire front side surface of the substrate 1, as it appears at the end of the preceding step, is covered with a layer of appropriate thickness of negative photoresist 10. The negative photoresist 10 is exposed by means of a mask, not shown in the figures, so that after development there remains uncovered a circular corona of palladium 7' with outside diameter D at the edge of the hole F.

The use of a negative photoresist ensures at the end of development the possibility of complete removal thereof from the interior of the hole F and the surrounding areas.

With reference to the same figure, in the areas of the palladium layer 7' free of photoresist 10 is grown galvanically a layer of gold 11 with standard thickness. At the end of the galvanic step the layer of gold 11 covers the following parts: the entire back side surface, which thus is an excellent ground plane, the metallization of the interior of the hole F and on the edge F' as well as said circular corona of palladium 7' at the edge of the hole F. Thanks to the regularity and continuity of the layers 6' and 7' the layer of gold 11 also grows every place regularly and in particular inside and at the edges of the hole F.

With reference to FIGS. 7 and 8 the photoresist 10 is eliminated entirely, after which is performed a selective chemical etching which removes the titanium layer 6' and palladium layer 7' from all the areas not covered by the gold layer 11. The methods and reagents employed in the selective chemical etching of the layers 6' and 7' are known to those skilled in the art. What remains is the desired product, i.e. a substrate 1 comprising on the front side a conductive path consisting of the layers 9, 6 and 7 broken by a resistive path 3 and, through a metallized hole F, connected to a ground plane lying on the back side of the same substrate. The product obtained is a complete passive circuit for applications in the microwave field, or it constitutes part of a hybrid circuit which will be completed by known technologies of surface mounting and welding of chip devices in hybrid circuits.

The process described lends itself to some interesting generalisations, e.g. the front side can include only conductive or only resistive paths. In the former case there are no particular provisions to be introduced in the steps already described while in the latter case the provision to be introduced is to arrange that at the point where the resistive path is to be connected to the ground plane on the back side, the masked area partially overlies the resistive path. Another generalisation is that of lengthening one or more conductive paths on the back side. In this case, again with reference to FIGS. 7 and 8, before galvanic growth of the layer of gold 11 there must be repeated also for the back side operations of photomasking analogous to those completed for the front side. Specifically the back side must be covered with a negative photoresist layer 10 on which are masked the areas affected by growth of back side conductive paths, not shown in the figures, at least one of these areas entirely overlying a hole F. After exposure and development there remain uncovered metallized areas on which can grow the layer of galvanic gold 11. The latter grows simultaneously on both sides in a single galvanic step. After which the residual photoresist 10 is eliminated all over and the final chemical etching removes the layers 6' and 7' in excess on the front side and back side. The excess layers are those deposited in areas which are outside the layer of gold 11 grown galvanically.

There is now discussed a variant on the above process, premissing everything stated up to the end of the step of drilling and cleaning of the drilled substrate with reference to FIG. 5. At this point, with reference to FIG. 9, the entire front side surface of the substrate 1 is covered by an appropriate layer of negative photoresist 10', subsequently exposed by means of an appropriate mask not shown in the figures, in such a manner that after development there remains uncovered a circular corona of outside diameter D on the layer of gold 9 at the edge of the hole F. The use of a negative photoresist is done for known reasons. In the case of the variant the requirement for a perfect cleaning of the holes and the adjacent areas is still more urgent and therefore there is introduced an additional step of plasma cleaning on the front side using in a known manner a flow of oxygen and argon.

With reference to FIG. 10 there follows a step of front & back deposition of a titanium layer 6'' on which is overlaid a palladium layer 7'', the thicknesses of the metallic layers 6'' and 7'' are standard. Even in this case it is convenient to use the deposition technique described in the above mentioned patent US-A-4226932. If it is desired to use other vacuum deposition techniques for the metals it is necessary to choose those in which heating of the substrate 1 is not called for, to avoid alterations of the photoresist 10'. Before the metallization it is also advisable to apply on the front side of the substrate 1 a peripheral corona, not shown in the figures, which would prevent deposition of metal along the contour of the substrate for reasons explained below. The metallization obtained at the end of the deposition step appears uniform and covers without a break the following parts: the entire back side surface, the wall delimiting the hole F in the body of the substrate 1, the area F' free of metal at the edge of the hole F, the circular corona free of photoresist on the layer of gold 9, and lastly the entire surface of the photoresist 10' on the front side. Any chipped edges of the substrate 1 at the edges of the hole F are covered uniformly by the deposited metals.

With reference to FIGS. 10 and 11 there is now performed a lift-off of the photoresist 10' from the front side of the substrate 1. The off-lifted photoresist entrains with it the overlying metallization 6'' and 7''. The lift-off operation is done by immersing the substrate for a predetermined time in a thermostatically controlled bath containing a chemical solution of known composition (stripper) depending on the type of photoresist used. The solution, agitated continuously by means of ultrasonics, begins to lift off the photoresist 10' starting from the edges of the substrate which, due to the above peripheral protection, are unmetallized. Gradually the stripping action moves towards the interior until all the photoresist 10' and the overlying metals are removed from the substrate 1. What remains are the metallizations shown in FIG. 11, i.e. the conductive path 2 and the resistive path 3 and the layers 6'' and 7''. The latter cover the following parts: the entire back side surface of the substrate 1, the wall delimiting the hole F, the area F' of the substrate 1, and lastly the circular corona of gold 9 at the edge of the hole F.

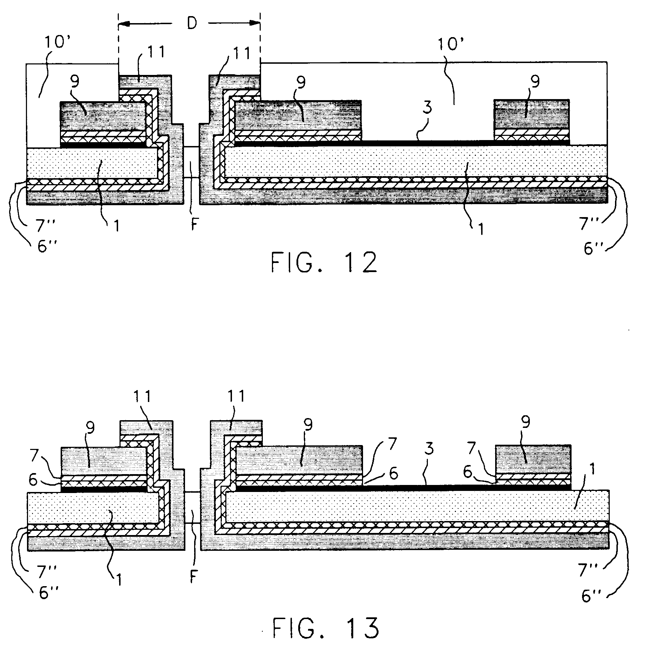

With reference to FIG. 12 there are repeated the steps of deposition of negative photoresist 10', photomasking and development, exactly as explained in the above discussion of FIG. 9. After development, in the areas free of photoresist 10' a layer of gold 11 having standard thickness is grown galvanically. At the end of the galvanic step the layer of gold 11 covers the following parts: the entire back side surface, which thus constitutes an excellent ground plane, metallization inside the hole F and on the edge F', as well as a circular corona of palladium 7'' at the edge of the hole F. Thanks to the regularity and continuity of the layer 6'' and 7'', even the layer of gold 11 grows everywhere regularly and in particular inside and at the edges of the hole F. To obtain the final product, coinciding with that shown in FIG 13, it is sufficient to eliminate the residual photoresist 10'.

As concerns the above mentioned generalisations on the presence of only conductive or only resistive paths on the front side, the same observations on the identical generalisations made for the main process apply to the variant.

As concerns the generalisation on extension of the conductive paths on the back side, in the case of the variant, one proceeds as follows: everything said up to the end of the lift-off step of the photoresist 10' for obtaining the metallizations 6'' and 7'' shown in FIG. 11 applies. After which the front & back sides are covered with a respective layer of negative photoresist 10', and on the front side are masked the areas overlying the holes in accordance with the procedures set forth above while on the back side are masked areas affected by growth of the conductive paths, not shown in FIG. 12, at least one of these back side areas entirely overlaying a hole F. After exposure and development front & back there remain uncovered areas of the palladium layer 7'' on which is grown a standard thickness of galvanic gold 11. The latter grows simultaneously on both sides in a single galvanic step, after which the residual negative photoresist 10' is eliminated all over. At this point only the front side is covered by a uniform layer of organic material which protects the underlying metallization from the subsequent final chemical etching, done to remove from the back side the layers 6'' and 7'' deposited in excess in the areas outside the layer of gold 11 grown galvanically. Lastly there is eliminated the organic material on the front side to obtain the finished product.

The process in accordance with the variant has more generalised use applicable both for the wide conductive lines and the fine lines. But it is technologically more complex than the main process because it includes the photoresist lift-off operation whose performance calls for good technical and practical skill. Therefore, when the width of the conductive paths is not less than approximately 50 µm the main process is preferable.

## Claims

1. Process for the provision of metallized through holes in a dielectric substrate (1) having front and back sides and conductive and/or resistive paths (2,3) covered with metallic layers (5,6,7) on the front side of the substrate, characterised in that it comprises in succession the following steps:
a) drilling of said substrate (1) in areas free of metallization of said conductive (2) and/or resistive paths (3),
b) thorough cleaning of said front and back side of the dielectric substrate (1) and of the walls delimiting the holes (F) in the body of the substrate,
c) vacuum cathode sputtering of metals (6',7') on said front and back sides and on the walls of the holes (F), achieving electrical continuity between the front and back side of the dielectric substrate (1) through the holes,
d) covering of the front side with a layer of a negative photosensitive emulsion (10), termed hereinafter photoresist, and masking of areas (D) entirely overlying the holes (F) and partially overlying said conductive (2) and/or resistive paths (3), exposure and development of the masked photoresist, achieving uncovered circular areas (D) around the front side edges of the holes (F),
e) galvanic growth of metal (11) over said front side uncovered circular areas (D) around the edges of holes (F), on said walls delimiting the holes in the body of the substrate, and on the all back side surface, forming a ground plane,
f) removal of the residual photoresist (10) from the front side, and
g) removal of said sputtered metals (6',7') which are uncovered from said galvanically grown metal (11) from the front side.

2. Process for the provision of metallized through holes in a dielectric substrate (1) having front and back sides and conductive and/or resistive paths (2,3) covered with metallic layers (5,6,7) on the front side of the substrate, characterised in that it comprises in succession the following steps:
a1) drilling of said substrate (1) in areas free of metallization of said conductive (2) and/or resistive paths (3),
b1) thorough cleaning of said front and back side of the dielectric substrate (1) and of the walls delimiting the holes (F) in the body of the substrate,
c1) vacuum cathode sputtering of metals (6',7') on said front and back sides and on the walls of the holes (F), achieving electrical continuity between the front and back side of the dielectric substrate (1) through the holes,
d1) covering of the front side with a layer of a negative photosensitive emulsion (10'), termed hereinafter photoresist, and masking of areas (D) entirely overlying the holes (F) and partially overlying said conductive (2) and/or resistive paths (3), exposure and development of the masked photoresist, achieving uncovered circular areas (D) around the front side edges of the holes (F),
d2) covering of the back side with a layer of a negative photoresist and masking of areas on which back side conductive paths shall be grown, at least one said masked area (D) entirely overlying a hole (F), exposure and development of the masked photoresist achieving uncovered back side areas,
e1) galvanic growth of metal (11) over said uncovered front and back side areas (D) and on the walls delimiting the holes in the body of the substrate,
f1) removal of the residual photoresist (10') from the front and back side, and
g1) removal of said sputtered metals (6',7') which are uncovered by said galvanically grown metal (11) from the front and back side.

3. Process for the provision of metallized holes in a dielectric substrate having conductive and/or resistive paths in accordance with claim 1 or 2, characterised in that said cathode sputtered metals are deposited forming an adhesion layer (6') on which is overlain a conductive metallic layer with antidiffusive properties (7').

4. Process for the provision of metallized holes in a dielectric substrate having conductive and/or resistive paths in accordance with claim 3, characterised in that said adhesion layer (6') consists of titanium and said conductive metallic layer with antidiffusive properties (7') consists of palladium.

5. Process for the provision of metallized holes in a dielectric substrate having conductive and/or resistive paths in accordance with claim 1 or 2, characterised in that said galvanically grown metal (11) is gold.

6. Process for the provision of metallized holes in a dielectric substrate having conductive and/or resistive paths in accordance with claim 1 or 2, characterised in that said step g), or g1), of removal of said metals (6',7') is selective chemical etching.

7. Process for the provision of metallized through holes in a dielectric substrate (1) having front and back sides and conductive and/or resistive paths (2,3) covered with metallic layers (5,6,7) on the front side of the substrate, characterised in that it comprises in succession the following steps:
I) drilling of said substrate (1) in areas free of the metallization of said conductive (2) and/or resistive paths (3),
m) thorough cleaning of said front and back side of the dielectric substrate (1) and of the walls delimiting the holes (F) in the body of the substrate,
n) covering of the front side with a layer of a negative photosensitive emulsion (10'), termed hereinafter photoresist, and masking of areas (D) entirely overlying the holes (F) and partially overlying said conductive (2) and/or resistive paths (3), exposure and development of the masked photoresist, achieving uncovered circular areas (D) of the bare substrate (1) at the front side edges of the holes (F),
o) thorough cleaning of said bare areas (D) at the edges of the holes (F) and inside them,
p) vacuum cathode sputtering of metals (6",7") over the front side residual photoresist (10'), on said circular areas (D) of the bare substrate at the edges of the holes, on said walls delimiting the holes (F) in the body of the substrate, and on the all surface of the back side, achieving electrical continuity between the front and back side of the dielectric substrate (1) through the holes,
q) lift-off of said residual photoresist (10') and of the metals (6",7") overlying it from said front side,
r) covering of the front side with a layer of a negative photoresist (10') and masking of areas (D) entirely overlying the holes (F) and partially overlying said conductive (2) and/or resistive paths (3), exposure and development of the masked photoresist achieving uncovered circular areas (D) of said sputtered metals (6",7"), residual after lift-off, at the front side edges of the holes,
s) galvanic growth of metal (11) over said front side uncovered circular areas (D) of the residual sputtered metals (6",7"), on said walls delimiting the holes in the body of the substrate, and on the all back side surface, forming a ground plane, and
t) removal of said residual photoresist (10') from the front side.

8. Process for the provision of metallized through holes in a dielectric substrate (1) having front and back sides and conductive and/or resistive paths (2,3) covered with metallic layers (5,6,7) on the front side of the substrate, characterised in that it comprises in succession the following steps:
l1) drilling of said substrate (1) in areas free of the metallization of said conductive (2) and/or resistive paths (3),
m1) thorough cleaning of said front and back side of the dielectric substrate (1) and of the walls delimiting the holes (F) in the body of the substrate,
n1) covering of the front side with a layer of a negative photosensitive emulsion (10'), termed hereinafter photoresist, and masking of areas (D) entirely overlying the holes (F) and partially overlying said conductive (2) and/or resistive paths (3), exposure and development of the masked photoresist, achieving uncovered circular areas (D) of the bare substrate (1) at the front side edges of the holes (F),
o1) thorough cleaning of said bare areas (D) at the edges of the holes (F) and inside them,
p1) vacuum cathode sputtering of metals (6",7") over the front side residual photoresist (10'), on said circular areas (D) of the bare substrate at the edges of the holes, on said walls delimiting the holes (F) in the body of the substrate, and on the all back side surface, achieving electrical continuity between the front and back side of the dielectric substrate (1) through the holes,
q1) lift-off of said residual photoresist (10') and of the metals (6",7") overlying it from said front side,
r1) covering of the front side with a layer of a negative photoresist (10'), and masking of areas (D) entirely overlying the holes (F) and partially overlying said conductive (2) and/or resistive paths (3), exposure and development of the masked photoresist, achieving uncovered circular areas (D) of said sputtered metals (6",7"), residual after lift-off, at the front side edges of the holes,
r2) covering of the back side with a layer of negative photoresist and masking of areas on which back side conductive paths shall be grown, at least one said masked area (D) entirely overlying a hole (F), exposure and development of the masked photoresist achieving uncovered back side areas,
s1) galvanic growth of metal (11) over said uncovered front and back side areas (D) and on the walls delimiting the holes in the body of the substrate,
t1) removal of the residual photoresist (10') from the front and back side,
u) covering of the front side with a uniform layer of protective organic material,
v) removal of said sputered metals (6",7") uncovered by said metal (11) galvanically grown on the back side, obtaining back side conductive paths, and
z) removing from the front side of said protective organic material.

9. Process for the provision of metallized holes in a dielectric substrate having conductive and/or resistive paths in accordance with claim 7 or 8, characterised in that said thorough cleaning performed in step m), or m1), is performed chemically and that said thorough cleaning performed in step o), or ol), is performed using an appropriate gas plasma.

10. Process for the provision of metallized holes in a dielectric substrate having conductive and/or resistive paths in accordance with claim 7 or 8, characterised in that said cathode sputtered metals are deposited forming an adhesion layer (6") on which is overlain a conductive metallic layer with antidiffusive properties (7").

11. Process for the provision of metallized holes in a dielectric substrate having conductive and/or resistive paths in accordance with claim 10, characterised in that said adhesion layer (6") consists of titanium and said conductive metallic layer with antidiffusive properties (7") consists of palladium.

12. Process for the provision of metallized holes in a dielectric substrate having conductive and/or resistive paths in accordance with claim 7 or 8, characterised in that said galvanically grown metal (11) is gold.

13. Process for the provision of metallized holes in a dielectric substrate having conductive and/or resistive paths in accordance with claim 8, characterised in that said step v) of removal of said metals (6",7") is a selective chemical etching.

## Patentansprüche

1. Verfahren zur Herstellung von metallischen Löchern in einem dielektrischen Substrat (1) mit Vorder- und Rückseite und Leiter- und/oder Widerstandsbahnen (2, 3) überzogen mit metallischen Schichten (5, 6, 7) auf der Vorderseite des Substrats, dadurch gekennzeichnet, daß es aufeinanderfolgend die folgenden Schritte umfaßt:
a) Bohren des genannten Substrats (1) in Zonen, die frei von Metallauftragungen der genannten Leiter- (2) und/oder Widerstandbahnen (3) sind,
b) sorgfältiges Reinigen der genannten Vorder- und Rückseite des dielektrischen Substrats (1) und der Wände, die die Löcher (F) im Körper des Substrats begrenzen,
c) Aufdampfen im Vakuum von Metallen (6', 7') auf die genannten Vorder- und Rückseiten und auf den Wänden der Löcher (F), wobei eine elektrische Kontinuität zwischen der Vorder- und Rückseite des dielektrischen Substrats (1) durch die Löcher erreicht wird,
d) Überziehen der Vorderseite mit einer Schicht einer negativen photosensiblen Emulsion (10), die nachstehend Photoresist genannt wird, und Abdeckung von Zonen (D), die die Löcher (F) vollkommen überlagern und teilweise die genannten Leiter- (2) und/oder Widerstandsbahnen (3) überlagern, Exposition und Entwicklung, wodurch man unbedeckte kreisförmige Zonen (D) um die Rändern der Löcher (F) an der Vorderseite erhält,
e) galvanische Zunahme von Metall (11) über die genannten unbedeckten, kreisförmigen Zonen (D) an der Vorderseite um die Ränder der Löcher (F), auf den genannten Wänden, die die Löcher im Körper des Substrats begrenzen, und auf der ganzen Oberfläche der Rückseite, wodurch eine Grundlage geschaffen wird.,
f) Entfernung des restlichen Photoresists (10) von der Vorderseite, und
g) Entfernung der genannten pulverisierten Metalle (6', 7'), die unbedeckt vom genannten galvanisch zugenommenen Metall (11) verblieben sind, von der Vorderseite.

2. Verfahren zur Hersteilung metallisierten Durchgangslöchern in einem dielektrischen Sustrat (1) mit Vorder- und Rückseiten und Leiter- und/oder Widerstandsbahnen (2, 3) überdeckt mit metallischen Schichten (5, 6, 7) auf der Vorderseite des Substrats, dadurch gekennzeichnet, daß es aufeinanderfolgend folgende Schritte umfaßt:
a1) Bohren des genannten Substrats (1) in Zonen, die frei von Metallisierung der genannten Leiter- (2) und/oder Widerstandsbahnen (3) sind,
b1) sorgfältiges Reinigen der Vorder- und Rückseite des dielektrischen Substrats (1) und der Wände, die die Löcher (F) im Körper des Substrats begrenzen,
c1) Aufdampfen im Vakuum von Metallen (6', 7') auf den genannten Vorder- und Rückseiten und auf den Wänden der Löcher (F), wodurch eine elektrische Kontinuität zwischen der Vorder- und Rückseite des dielektrischen Substrats (1) durch die Löcher erreicht wird,
d1) Überziehen der Vorderseite mit einer Schicht einer negativ photosensiblen Emulsion (10'), nachstehend Photoresist genannt, und Abdeckung von Zonen (D), die vollkommen die Löcher (F) und teilweise die genannten Leiter (2) und/oder Widerstandsbahnen (3) überdecken, Exposition und Entwicklung des abgedeckten Photoresist und, wodurch man unbedeckte, kreisförmige Zonen (D) um die Ränder auf der Vorderseite der Löcher (F) erhält,
d2) Überziehen der Rückseite mit einer Schicht einer negativen Photoresists und Abdecken von Zonen, auf deren Rückseite Leiterbahnen sich ausbreiten sollen, wobei wenigstens eine der genannten abgedeckten Zonen (D) ein Loch (F) vollkommen überdeckt, Exposition und Entwicklung der abgedeckten Photoresists, wodurch man unbedeckte Rückseitenzonen erhält,
e1) galvanische Zunahme von Metall (11) über die genannten Zonen (D) der Vorder- und Rückseite und auf den Wänden, die die Löcher im Körper des Substrats begrenzen,
f1) Entfernung des restlichen Photoresists (10') von der Vorder- und Rückseite, und
g1) Entfernung der genannten pulverisierten Metalle (6', 7') von der Vorder- und Rückseite, die nicht durch das galvanisch ausgebreitete Metall (11) bedeckt werden.

3. Verfahren zur Herstellung von metallisierten Löchern in einem dielektrischen Substrat mit Leiter- und/oder Widerstandsbahnen entsprechend Anspruch 1 oder 2, dadurch gekennzeichnet, daß die genannten, im Vakuum aufgedampften Metalle sich so setzen, daß sie eine Haftbeschichtung (6') bilden, die von einer leitenden, metallischen Schicht mit antidiffusiven Eigenschaften (7') überdeckt wird.

4. Verfahren zur Herstellung von metallisierten Löchern in einem dielektrischen Substrat mit Leiter- und/oder Widerstandsbahnen entsprechend Anspruch 3, dadurch gekennzeichnet, daß die genannte Haftschicht (6') aus Titan und die genannte leitende, metallische Schicht aus Palladium besteht.

5. Verfahren zur Herstellung von metallisierten Löchern in einem dielektrischen Substrat mit Leiter- und/oder Widerstandsbahnen entsprechend Anspruch 1 oder 2, dadurch gekennzeichnet, daß das galvanisch ausgebreitete Metall (11) Gold ist.

6. Verfahren zur Herstellung von metallisierten Löchern in einem dielektrischen Substrat mit Leiter- und/oder Widerstandbahnen entsprechend Anspruch 1 oder 2, dadurch gekennzeichnet, daß es sich bei dem genannten Schritt g) oder g1) betreffs der Entfernung der genannten Metalle (6', 7') um selektives chemisches Ätzen handelt.

7. Verfahren zur Herstellung von metallisierten Löchern in einem dielektrischen Substrat (1) mit Vorder- und Rückseiten und Leiter- und/oder Widerstandsbahnen (2, 3) die mit metallischen Schichten (5, 6, 7) auf der Vorderseite des Substrats bedeckt sind, dadurch gekennzeichnet, daß es aufeinanderfolgend folgende Schritte umfaßt:
l) Bohren des genannten Substrats (1) in Zonen, die frei von Metallisierungen der genannten Leiter- (2) und/oder Widerstandsbahnen (3) sind,
m) sorgfältiges Reinigender genannten Vorder- und Rückseite des dielektrischen Substrats (1) und der Wände, die die Löcher (F) im Körper des Substrats begrenzen,
n) Überziehen der Vorderseite mit einer Schicht einer negativ photosensiblen Emulsion (10'), nachstehend Photoresist genannt, und Abdeckung von Zonen (D), die die Löcher (F) vollkommen und teilweise die genannten Leiter- (2) und/oder Widerstandsbahnen (3) überdecken, Exposition und Entwicklung von abgedeckten Photoresists, wodurch man nicht abgedeckte, kreisförmige Zonen (D) des nackten Substrats (1) an den Rändern der Löcher (F) auf der Vorderseite erhält,
o) sorgfältiges Reinigen der genanten nackten Zonen (D) an den Rändern der Löcher (F) und in ihnen,
p) Aufdampfen im Vakuum von Metallen (6', 7') über den restlichen Photoresist auf der Vorderseite, auf den genannten kreisförmigen Zonen (D) des nackten Substrats an den Rändern der Löcher, auf den Wänden, die die Löcher (F) im Körper des Substrats begrenzen, und auf der gesamten Oberfläche der Rückseite, wodurch man eine elektrische Kontinuität zwischen der Vorder- und der Rückseite des dielektrischen Substrats (1) durch die Löcher erhält,
q) Entfernung des restlichen Photoresists (10') und der Metalle (6", 7"), die ihn von der genannten Vorderseite überdecken,
r) Überdecken der Vorderseite mit einer Schicht eines negativen Photoresists (10') und Abdecken von Zonen, die die Löcher (F) vollkommen und teilweise die genannten Leiter- (2) und Widerstandsbahnen (3) abdecken, Exposition und Entwicklung des abgedeckten Photoresists, wodurch man unbedeckte, kreisförmige Zonen (D) der genannten aufgedampften Metalle (6", 7"), die nach der Abnahme an den Rändern der Löcher an der Vorderseite verbleiben,
s) galvanisches Ausbreiten von Metall (11) über die genannten unbedeckten, kreisförmigen Zonen (D) der verbleibenden aufgedampften Metalle (6", 7"), auf den genannten Wänden, die die Löcher im Körper des Substrats begrenzen. und auf der gesamten Oberfläche der Rückseite, wodurch eine Grundlage geschaffen wird, und
t) Entfernung des genannte restlichen Photoresists (10') von der Vorderseite.

8. Verfahren zur Herstellung von metallisierten durchgehenden Löchern in einem dielektrischen Substrat (1) mit Vorder- und Rückseiten und Leiter- (2) und/oder Widerstandsbahnen (3) überdeckt mit metallischen Schichten (5, 6, 7) auf der Vorderseite des Substrats, dadurch gekennzeichnet, daß es aufeinanderfolgend folgende Schritte umfaßt:
l1) Bohren des genannten Substrats (1) in Zonen, die frei von Metallisierungen der genannten Leiter- (2) und/oder Widerstandsbahnen (3) sind,
m1) Sorgfältiges Reinigen der genannten Vorder- und Rückseite des dielektrischen Substrats (1) und der Wände, die die Löcher (F) im Körper des Substrats begrenzen,
n1) Überziehen der Vorderseite mit einer Schicht aus einer negativ photosensiblen Emulsion (10'), nachfolgend Photoresist genannt, und Abdeckung von Zonen (D) die die Löcher (F) vollkommen und die genannten Leiter- (2) und Widerstandsbahnen (3) teilweise überdecken, Exposition und Entwicklung des abgedeckten Photoresists, wodurch man unbedeckte, kreisförmige Zonen (D) des nackten Substrats (1) an der Vorderseite an den Rändern der Löcher (F) erhält,
o1) Sorgfältiges Reinigen der nackten Zonen (D) an den Rändern der Löcher (F) und in ihnen,
p1) Aufdampfen im Vakuum von Metallen (6", 7") über dem vorderseitigen, restlichen Photoresist (10'), auf den genannten kreisförmigen Zonen (D) des nackten Substrats an den Rändern der Löcher, auf den genannten Wänden, die die Löcher (F) im Körper des Substrats begrenzen, und auf der gesamten rückseitigen Oberfläche, wodurch man eine elektrische Kontinuität zwischen der Vorder- und der Rückseite des dielektrischen Substrats (1) durch die Löcher erhält,
q1) Abnahme des genannten restlichen Photoresists (10') und der diesen abdeckenden Metalle (6", 7") von der genannten Vorderseite,
r1) Überdecken der Vorderseite mit einer Schicht aus einem negativen Photoresist (10') und Abdeckung von Zonen (D), die die Löcher (F) vollkommen und die genannten Leiter- (2) und/oder Widerstandsbahnen (3) teilweise abdecken, Exposition und Entwicklung des abgedeckten Photoresists, wodurch man unbedeckte, kreisförmige Zonen (D) der genannten aufgedampften Metalle (6", 7"), die nach der Abnahme an den vorderseitigen Rädern der Löcher verbleiben,
r2) Abdecken der Rückseite mit einer Schicht eines negativen Photoresists und Abdecken von Zonen, auf der rückseitige Leiterbahnen verwirklicht werden sollen, wobei mindestens eine genannte abgedeckte Zone (D) ein Loch (F) vollkommen abdeckt, Exposition und Entwicklung des abgedeckten Photoresists, wodurch man unbedeckte rückseitige Zonen erhält,
s1) galvanisches Ausbreiten von Metall (11) über die genannten unbedeckten vorder- und rückseitigen Zonen (D) und auf den Wänden, die die Löcher im Körper des Substrats begrenzen,
t1) Entfernung des restlichen Photoresists (10') von der Vorder- und Rückseite,
u) Überdecken der Vorderseite mit einer gleichförmigen Schicht eines schützenden, organischen Materials,
v) Entfernung der genannten aufgedampften Metalle (6", 7"), die nicht durch das genannte, galvanisch auf der Rückseite ausgebreitete Metall (11) überdeckt sind, wodurch man rückseitige Leiterbahnen erhält,
z) Entfernung des genannten schützenden organischen Materials von der Vorderseite.

9. Verfahren zur Herstellung von metallisierten Löchern in einem dielektrischen Substrat mit Leiter- und/oder Widerstandsbahnen entsprechend Anspruch 7 oder 8, dadurch gekennzeichnet, daß das genannte in Schritt m) oder m1) ausgeführte sorgfältige Reinigen auf chemischem Wege ausgeführt wird und daß das in Schritt o) oder o1) ausgeführte sorgfältige Reinigen durch Anwendung eines geeigneten Plasmagases durchgeführt wird.

10. Verfahren zur Herstellung von metallisierten Löchern in einem dielektrischen Substrat mit Leiter und/oder Widerstandsbahnen entsprechend Anspruch 7 oder 8, dadurch gekennzeichnet, daß die genannten aufgedampften Metalle sich so ablagern, daß sie eine Haftschicht (6") bilden, die von einer metallischen Leitschicht mit antidiffusiven Eigenschaften (7") überlagert wird

11. Verfahren zur Herstellung von metallisierten Löchern in einem dielektrischen Substrat mit Leiter- und/oder Widerstandsbahnen entsprechend Anspruch 10, dadurch gekennzeichnet, daß die genannte Haftschicht (6") aus Titan und die genannte metallische Leitschicht mit antidiffusiven Eigenschaften (7") aus Palladium besteht.

12. Verfahren zur Herstellung von metallisierten Löchern in einem dielektrischen Substrat mit Leiter- und/oder Widerstandsbahnen entsprechend Anspruch 7 oder 8, dadurch gekennzeichnet, daß das genannte galvanisch ausgebreitete Metall (11) Gold ist.

13. Verfahren zur Herstellung von metallisierten Löchern in einem dielektrischen Substrat mit Leiter- und/oder Widerstandsbahnen entsprechend Anspruch 8, dadurch gekennzeichnet, daß der genannte Schritt v) betreffs der Entfernung des genannten Metalle (6", 7") ein selektiver chemischer Ätzungsverfahren ist.

## Revendications

1. Procédé pour la production de trous métallisés dans un substrat diélectrique (1) avec côté avant et côté postérieur et des voies conductrices et/ou résistives (2, 3) couvertes de couches métalliques (5, 6, 7) sur le côté avant du substrat, caractérisé en ce qu'il comprend successivement le phases suivantes:
a) forage du dit substrate (1) dans les zones sans métallisation des dites voies conductrices (2) et/ou résistives (3),
b) nettoyage minutieux du côté avant et postérieur du substrat diélectrique (1) et des parois, qui délimitent les trous (F) dans le corps du substrat,
c) pulvérisation cathodique sous vide de métaux (6', 7') sur les dits côtés avant et postérieur et sur les parois des trous (F) réalisant une continuité électrique entre le côté avant et celui postérieur du substrat diélectrique (1) à travers les trous,
d) couverture du côté avant avec une couche d'une émulsion photosensible négative (10) appelée par la suite "photoresist" et couverture des zones (D) qui superposent entièrement les trous (F) et qui superposent partiellement les dites voies conductrices (2) et/ou résistives (3), exposition et développement du photoresist masqué, obtenant des zones circulaires non couvertes (D) autour des bords des trous (F) du côté avant,
e) accroissement galvanique de métal (11) sur les dites zones circulaires non couvertes du côté avant (D) autour des bords des trous, sur les dites parois, qui délimitent les trous dans le corps du substrat, et sur toute la surface du côté postérieur formant un fondement,
f) enlèvement du photoresist (10) restant du côté avant, et
g) enlèvement des dits métaux pulvérisés (6', 7'), qui résultent extérieurs au dît métal crû de manière galvanique du côté avant.

2. Procédé pour la production de trous métallisés dans un substrat diélectrique (1) avec un côté avant et un côté postérieur et des voies conductrices et/ou résitives (2, 3) couverts de couches métalliques (5, 6, 7) sur le côté avant du substrat, caractérisé en ce qu'il comprend les phases suivantes:
a1) forage du dît substrat (1) dans les zones sans métallisation des dites voies conductrices (2) et/ou résistives (3),
b1) nettoyage minutieux du côté avant et postérieur du substrat diélectrique (1) et des parois, qui délimitent les trous (F) dans le corps du substrat,
c1) pulvérisation cathodique sous vide des métaux (6', 7') sur les dits côtés avant et postérieur et sur les parois des trous (F) réalisant une continuité électrique entre le côté avant et celui postérieur du substrat diélectrique (1) à travers les trous,
d1) couverture du côté avant avec une couche d'une émulsion photosensible négative (10) appelée par la suite photoresist et couverture des zones (D), qui superposent entièrement les trous (F) et qui superposent partiellement les dites voies conductrices (2) et/ou résistives (3), exposition et développement du photoresist masqué, obtenant des zones circulaires non couvertes (D) autour des bords des trous (F) du coté avant,
d2) couverture du côté postérieur avec une couche d'un photoresist négatif et couverture de zones sur le côté postérieur desquelles des voies conductrices seront étendues, avec au moins une des zones masquées (D), qui superpose un trou (F), exposition et développement des photoresists masqués obtenant des zones non couvertes sur le côté postérieur,
e1) accroissement galvanique de métal (11) sur les dites zones non couvertes sur le côté avant et celui postérieur (D) et sur les parois, qui délimitent les trous dans le corps du substrat,
f1) enlèvement du photoresist (10') des côtes avant et postérieur, et
g1) enlèvement des dits métaux (6', 7'), qui résultent extérieurs au dît métal crû de manière galvanique du côté avant et postérieur.

3. Procédé pour la production de trous métallisés dans un substrat diélectrique avec des voies conductrices et/ou résistives selon la revendication 1 ou 2, caractérisé en ce que les métaux pulvérisés de manière cathodique sont déposés formant une couche adhésion (6'), sur lequel une couche métallique conductrice avec des propriétés antidiffusives (7') est superposée.

4. Procédé pour la production de trous métallisés dans un substrat diélectrique avec des voies conductrices et/ou résistives selon la revendication 3, caractérisé en ce que la dite couche d'adhésion (6') consiste en titane et la dite couche métallique conductrice avec des propriétés antidiffusives (7') consiste en palladium.

5. Procédé pour la production de trous métallisés dans un substrat diélectrique avec des voies conductrices et/ou résistives selon la revendication 3, caractérisé en ce que le métal étendu de manière galvanique est de l'or.

6. Procédé pour la production de trous métallisés dans un substrat diélectrique avec des voies conductrices et/ou résistives selon la revendication 1 ou 2, caractérisé en ce que la dite phase g) ou g1) d'enlèvement des dits métaux (6', 7') est une gravure chimique sélective.

7. Procédé pour la production de trous métallisés dans un substrat diélectrique (1) avec des côtés avant et postérieur et des voies conductrices et/ou résitives (2, 3) couvertes de couches métalliques (5, 6, 7) sur le côté avant du substrat, caractérisé en ce qu'il comprend successivement les phases suivantes:
l) forage du dît substrat (1) dans des zones sans la métallisation des dites voies conductrices (2) et/ou résistives (3),
m) nettoyage minutieux du côté avant et postérieur d'un substrat diélectrique (1) et des parois, qui délimitent les trous (F) dans le corps du substrat,
n) couverture du côté avant avec une couche d'une émulsion photosensible négative (10') appelée par la suite photoresist et couverture de zones, qui superposent entièrement les trous (F) et partiellement les dites voies conductrices et/ou résistives (3), exposition et développement des photoresists masqués obtenant des zones circulaires découvertes (D) de substrat nu (1) aux bords du côté avant des trous (F),
o) nettoyage minutieux des dites zones nue (D) aux bords des trous et à leur intérieur,
p) pulvérisation cathodique sous vide de métaux (6", 7") sur le photoresist (10') restant du côté avant, sur les dites zones circulaires (D) du substrat nu aux bords des trous, sur les dites parois, qui délimitent les trous (F) dans le corps du substrat, et sur toutes les surfaces du côté postérieur, obtenant de la continuité électrique entre le côté avant et le côté postérieur du substrat diélectrique (1) à travers les trous,
q) enlèvement du photoresist restant (10') et des métaux (6", 7"), qui le recouvrent du dît côté avant,
r) couverture du côté avant avec une couche d'un photoresist négatif (10') et couverture de zones (D) entièrement couvrantes les trous (F) et partiellement les dites voies coductrices (2) et/ou résistives (3), exposition et développement du photoresist masqué obtenant des zones circulaires découvertes (D) des dits métaux pulvérisés (6", 7") restants après l'enlèvement aux bords du côté avant des trous,
s) application de métal de manière galvanique (11) sur les dites zones circulaires découvertes du côté avant (D) de métaux pulvérisés restants (6", 7"), sur les dites parois, qui délimite des trous dans le corps du substrat et sur toute la surface du côté postérieur formant une base, et
t) enlèvement du dît photoresist restant (10') du côté avant.

8. Procédé de production de trous métallisés dans un substrat diélectrique (1) ayant des côtés avant et postérieur et des voies conductrices et/ou résistives (2, 3) couvertes de couches métalliques (5, 6, 7) sur le côté avant du substrat, caractérisé en ce qu'il comprend successivement les phases suivantes:
l1) forage du dît substrat (1) dans des zones sans la métallisation des dites voies conductrices (2) et/ou résistives (3),
m1) nettoyage minutieux du dît côté avant et du dît côté postérieur du substrat diélectrique (1) et des parois, qui délimitent les trous (F) dans le corps du substrat,
n1) couverture du côté avant avec une couche d'une émulsion photosensible négative (10') ) appelée par la suite photoresist, et couverture de zones (D), qui couvrent entièrement les trous (F) et partiellement les dites voies conductrices (2) et/ou résistives (3), exposition et développement du photoresist masqué, obtenant des zones circulaires découvertes (D) du substrat nu (1) aux bords de côté avant des trous (F),
o1) nettoyage minutieux des zones nues (D) aux bords des trous (F) et à leur intérieur,
p1) pulvérisation cathodique sous vide de métaux (6", 7") sur le photoresist restant (10'), sur les dites zones circulaires (D) du substrat nu aux bords des trous, sur les dites parois, qui délimitent les trous (F) dans le corps du substrat et sur toute la surface du côté postérieur réalisant une continuité électrique entre le côté avant et le côté postérieur du substrat diélectrique (1) à travers les trous,
q1) enlèvement du dît photoresist restant (10') et des métaux (6", 7"), qui le couvrent du côté avant,
r1) couverture du côté avant avec une couche d'un photoresist négatif (10') ) et couverture de zones (D), qui couvrent entièrement les trous (F) et partiellement les dites voies conductrices (2) et/ou résistives (3), exposition et développement du photoresist masqué, obtenant des zones circulaires découvertes (D) des dits métaux pulvérisé (6", 7") restants après l'enlèvement du côté avant des trous,
r2) ) couverture du côté postérieur avec une couche de photoresist négatif et couverture de zones sur lesquelles des voies conductrices seront étendues, au moins une zone masquée (D), qui couvre entièrement un trou (F), exposition et développement du photoresist masqué obtenant des zones découvertes du côté postérieur,
s1) accroisement de métal de manière galvanique (11) sur les dites zones découvertes du côté avant et du côté postérieur (D) et sur les parois, qui délimitent les trous dans le corps du substrat,
t1) enlèvement du photoresist restant (10') ) du côté avant et du côté postérieur,
u) couverture du côté avant par une couche uniforme de matériel organique protecteur,
v) enlèvement des dits métaux pulvérisés (6", 7"), qui ne sont pas couverts par le dît métal (11) appliqué de manière galvanique sur le côté postérieur obtenant des voies conductrices du côté postérieur, et
z) enlèvement du côté avant du dît matériel organique protecteur.

9. Procédé pour la production de trous métallisés dans un substrat diélectrique ayant des voies conductrices et/ou résistives selon la revendication 7 ou 8, caractérisé en ce que le nettoyage minutieux est effectué pendant la phase m) ou m1) est effectué chimiquement et que le dît nettoyage minutieux effectué pendant la phase o) ou ol) est effectué en utilisant un plasma de gaz approprié.

10. Procédé pour la production de trous métallisés dans un substrat diélectrique ayant des voies conductrices et/ou resistives selon la revendication 7 ou 8, caractérisé en ce que les dits métaux pulvérisés de manière cathodique se déposent en formant une couche d'adhésion (6"), sur laquelle est superposée une couche métallique conductrice avec des propriété antidiffisives (7").

11. Procédé pour la production de trous métallisés dans un substrat diélectrique ayant des voies conductrices et/ou resistives selon la revendication 10, caractérisé en ce que la dite couche d'adhésion (6") consiste en titane et la dite couche métallique conductrice avec des propriété antidiffusives (7") consiste en palladium.

12. Procédé pour la production de trous métallisés dans un substrat diélectrique ayant des voies conductrices et/ou résistives selon la revendication 7 ou 8, caractérisé en ce que le dit métal appliqué de manière galvanique est de l'or.

13. Procédé pour la production de trous métallisés dans un substrat diélectrique ayant des voies conductrices et/ou résistives selon la revendication 8, caractérisé en ce que la dite phase v) d'enlèvement des dits métaux (6", 7") est une gravure chimique sélective.
